# EUROPÄISCHE PATENTSCHRIFT

(11) **EP 0 800 338 B1**
(45) Veröffentlichungstag und Bekanntmachung des Hinweises auf die Patenterteilung: **30.05.2001**
(21) Anmeldenummer: 97105474.7
(22) Anmeldetag: 02.04.1997
(51) Int. Cl.: H05K 9/00

(54) **Anordnung zur Reduzierung der elektromagnetischen Abstrahlung bei Leiterkarten und anderen Trägern elektronischer Schaltungen**
Devices for minimising electromagnetic radiation in printed circuit boards and other electronic circuit carriers
Dispositif réduisant les radiations électromagnétiques dans les circuits imprimés et autres supports de circuits électroniques

(30) Priorität: 04.04.1996 DE 19613587; 20.05.1996 DE 19620194
(43) Veröffentlichungstag der Anmeldung: 08.10.1997
(73) Patentinhaber: Langer, Gunter, D-01728 Bannewitz (DE)
(72) Erfinder: Langer, Gunter, D-01728 Bannewitz (DE)
(74) Vertreter: Heyner, Klaus, Dr.-Ing.

(56) Entgegenhaltungen:
- WO-A-94/18812
- DE-A- 3 838 486
- DE-A- 4 327 766
- DE-A- 19 507 124
- US-A- 3 093 805
- US-A- 4 954 929
- "CIRCUIT BOARD GUARDING TECHNIQUES" RESEARCH DISCLOSURE, Nr. 314, 1.Juni 1990, Seite 524 XP000132379
- PATENT ABSTRACTS OF JAPAN vol. 015, no. 139 (E-1053), 9.April 1991 & JP 03 018113 A (MURATA MFG CO LTD), 25.Januar 1991,

## Beschreibung

Die Erfindung betrifft die Reduzierung bzw. Blockierung elektromagnetischer Abstrahlung von Leiterkarten, integrierten Schaltkreisen (IC) und Leiterkartengehäusen für den IC-Aufbau durch Maßnahmen am Layout und durch Bauelementebestückung.

Leiterkarten oder andere Träger elektronischer Schaltungen können auf Grund der Schaltvorgänge ihrer digitalen elektronischen Schaltungen hochfrequente elektromagnetische Wellen abstrahlen. Die Frequenz der Abstrahlung liegt im MHz- bis GHz-Bereich. Besonders hohe Abstrahlungswerte erzeugen schnelle, mit hoher Frequenz (MHz) periodisch arbeitende Digitalschaltungen insbesondere Schaltungen, die Mikrorechner enthalten.
Weiterhin wird die Funktion digitaler Schaltungen durch Störgrößen bedroht, die über Feld- und Leitungskopplungen von außen einwirken.

Durch Vorschriften zur elektromagnetischen Verträglichkeit (EMV) werden Grenzwerte für Geräte festgelegt. Um die vom Gesetzgeber geforderten Grenzwerte einzuhalten, sind vom Gerätehersteller an den Geräten bzw. Baugruppen bestimmte Maßnahmen zur EMV erforderlich.

Es sind eine Vielzahl von Maßnahmen zur Schirmung und Filterung bekannt. Maßnahmen, die direkt auf Leiterkarten speziell am Layout angewendet werden, stehen noch an den Anfängen (DE 195 07 124 A1, DE 43 27 766 A1, US 3093 805).

Aus DE 195 07 124 A1 ist eine Abdeckung einzelner Leiterzüge von Leiterkarten und IC mit leitfähigen Flächen an sich zu entnehmen. Weiterführende Anordnungen für das Zielgebiet der Erfindung sind nicht zu entnehmen.

Gegenstand von US 3093 805 sind Leiterbahnanordnungen auf Leiterplatten, bei denen auf der einen Seite einzelne Leiterzüge von GND-Leiterbahnen eingegrenzt sind und auf der anderen Seite eine GND-Abdeckung vorhanden ist. Die GND-Leiterbahnen sind mittels Durchkontaktierungen mit der GND-Abdeckung verbunden.

Aufgabe der Erfindung ist es deshalb, wirksame Mittel zur Verringerung der elektromagnetischen Abstrahlung von Leiterkarten und anderen Trägern elektronischer Schaltungen vorzuschlagen, die durch Maßnahmen am Layout und durch geeignete Bauelementebestückung direkt auf die vorliegenden Leiterzugbereiche elektronischer Schaltungen abgestimmt sind.

Eine erfindungsgemäße Lösung dieser Aufgabe ist Gegenstand der Patentansprüche 1 und 4.
Weiterbildungen der Erfindung sind in den Unteransprüchen enthalten.

Der Lösungsgedanke besteht darin, daß die BUS-Leiterzüge von Leiterkarten und IC, aber auch in analoger Weise die feinen Leiterzüge und Bonddrähte eines Chips oder Leiterkartengehäuses durch beabstandete Anordnung von leitfähigen Streifen und/oder Flächenelementen, die als Kompensationselemente wirken, abgedeckt sind, wobei diese Abdeckungen mindestens an ihren Eckpunkten oder an ihren Seitenkanten mit dem GND-System der zugehörigen Baugruppe verbunden sind.

Die Oberfläche von Busleitungssystemen ist besonders stark an der Abstrahlung von elektromagnetischen Wellen beteiligt. Die Signalleitungen einer digitalen Baugruppe sind, wenn sie mit zyklischen bzw. periodischen Signaländerungen hoher Frequenz (MHz) beaufschlagt sind, Quelle für elektromagnetische Störaussendungen.

Bei der erfindungsgemäßen Grundanordnung nach Anspruch 1 werden zur Lösung der erfindungsgemäßen Aufgabe kurzschlußringförmige Kompensationselemente mit ihrer Schleifenebene senkrecht zur Leiterkartenebene angeordnet. Die Kompensationselemente bestehen aus dem Kompensationsleiter und mindestens zwei Stegen, die mit dem GND-System der Leiterkarte verbunden sind. In einen Abstand von 1 bis 5 cm parallel zur Leiterkarte ist der stab- oder flächenförmige Kompensationsleiter angeordnet. Der Kompensationsleiter ist Teil eines Kurzschlußringes. Der Kurzschlußring wird aus dem Kompensationsleiter, mindestens zwei leitfähigen Stegen und dem GND-System der Leiterkarte oder einem weiteren leitfähigen Steg auf der Leiterkarte gebildet. Die leitfähigen Stege stehen senkrecht auf der Leiterkarte und kontaktieren auf einer Seite GND und auf der anderen Seite den Kompensationsleiter. Der gesamte Kompensationsleiter oder nur ein Abschnitt kann als Teil des Kurzschlußringes genutzt werden.
Der auf der Leiterkarte befindliche Teil des Kurzschlußringes kann von GND oder einem Leiterstreifen gebildet werden.
Der Kompensationsleiter hat die Funktion einer Antenne, die von zwei Stegen gespeist wird und die die Antennenwirkung der Leiterkarte zumindest teilweise kompensiert.

Die obigen Kompensationselemente für Leiterkarten können in einer kleineren Ausführung für einzelne IC verwendet werden. Passive IC-Kompensationselemente können mit GND verbunden werden, aktive mit einem aus der Hilfsenergieversorgung des IC abgezweigten Strom gespeist werden, vgl. Anspruch 3. Das Kompensationselement kann dabei aus einem oder mehreren Kompensationsleitern bestehen, die über oder neben dem IC angeordnet sind.

Die Anordnung von Kurzschlußringstrukturen läßt sich mit einer Grundanordnung nach Anspruch 4 auf mehr als zweilagige Leiterkarten (Multilayer) übertragen. Derartige Leiterkarten besitzen eine geschlossene GND- und Vcc-Plane. Diese besteht aus einer metallischen weitestgehend geschlossenen GND-Lage (Fläche A) und Vcc-Lage (Fläche B), die durch eine Isolierschicht getrennt übereinander liegen.

Wirksame Anordnungen ergeben sich, wenn die Kurzschlußringebene rechtwinklig zur Leiterkartenebene im Bereich der GND- und Vcc-Plane angeordnet wird. Der Kurzschlußring wird etwa 2 bis 10 cm auf der Ober- und Unterseite des GND/Vcc-Plane-Systems mittels der Leiter C und/oder D geführt und mit Durchkontaktierungen geschlossen. Dabei kann der Kurzschlußring von GND und Vcc isoliert oder mit einem der beiden Potentiale verbunden aufgebaut werden. Wesentlich ist, das die Durchkontaktierungen über Bohrungen durch die metallische Lagen geführt werden, d.h. nicht neben den metallischen Lagen A, B angeordnet werden. Um die Führung der Kurzschlußringe über Flächen und Leitungen unterschiedlicher Potentiale zu realisieren, können anstelle der Durchkontaktierungen Blockkondensatoren verwendet werden. Aktive Gebiete der GND/Vcc-Plane werden mit einer Kette von Kurzschlußringen umfaßt. Aktive Gebiete sind diejenigen, die oberhalb oder unterhalb der GND/Vcc-Plane die oben beschriebenen Busleitungen oder Bus-IC besitzen.

Die Leiterzüge C, D können auch auf Innenlagen angeordnet werden. In diesem Fall bestehen die äußeren Lagen aus Metallflächen A, B. Die Kurzschlußringe werden wiederum bei Flächen mit gleichen Potentialen durch Durchkontaktierungen realisiert und bei Flächen unterschiedlicher Potentiale mittels Blockkondensatoren.

Ausgangspunkt für eine weitere vorteilhafte Ausführung ist der Fall, daß eine Multilayerkarte ein oder mehrere GND-Plane aber keine Vcc-Plane, sondern ein Vcc-Leitungssystem besitzt. Das Vcc-Leitungssystem weist hier bei jedem IC einen Blockkondensator auf.

Erfindungsgemäß werden zur Reduzierung der elektromagnetischen Abstrahlung die zwischen Vcc-Anschluß des IC und GND-Plane befindlichen Blockkondensatorzuleitungen nicht wie bisher üblich, auf kürzestem Weg geführt. Der Blockkondensatorstromweg wird als Kompensationsleiter in Form eines Leiterzuges unter dem IC geführt. Der Blockkondensatorstromweg verläuft vom Vcc-Anschluß des IC unter dem IC bis zum GND-Anschluß des IC und ist dort mit GND-Plane verbunden.

In einer anderen Ausführung kann der Kompensationsleiter flächig ausgeführt sein, wobei die Leitergeometrie etwa dem Grundriß des IC angepaßt ist. Bei einer bevorzugten Ausführung ist der IC von einer GND-Umfassung mit der bereits beschriebenen Durchkontaktierung zu GND-Plane zumindest neben dem Kompensationsleiter umgeben.
Die Anordnung des Kompensationsleiters kann sowohl unter als auch in geteilter Form unter und/oder neben dem IC erfolgen.
In analoger Weise kann auch ein Bus mit einem Kompensationsleiter, der sich unter oder über dem Bus befindet, gekoppelt werden. Die Verbindung des Kompensationsleiters mit GND erfolgt am GND-Anschluß des den Bus treibenden IC.

Zur weiteren Erläuterung der Erfindung wird auf die Patentansprüche verwiesen.
Einzelheiten, Merkmale und Vorteile der Erfindung ergeben sich auch aus der nachfolgenden Beschreibung von Ausführungsbeispielen. In der zugehörigen Zeichnung zeigen:
- Fig. 1: die Anordnung von Kompensationselementen für Leiterkarten und IC und
- Fig. 2: verschiedene Kurzschlußringstrukturen für GND/Vcc-Plane Multilayer.

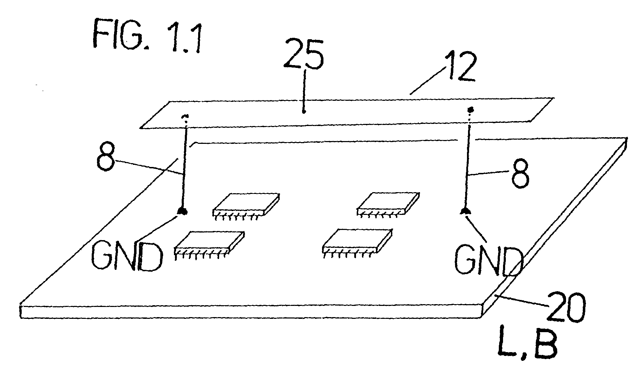

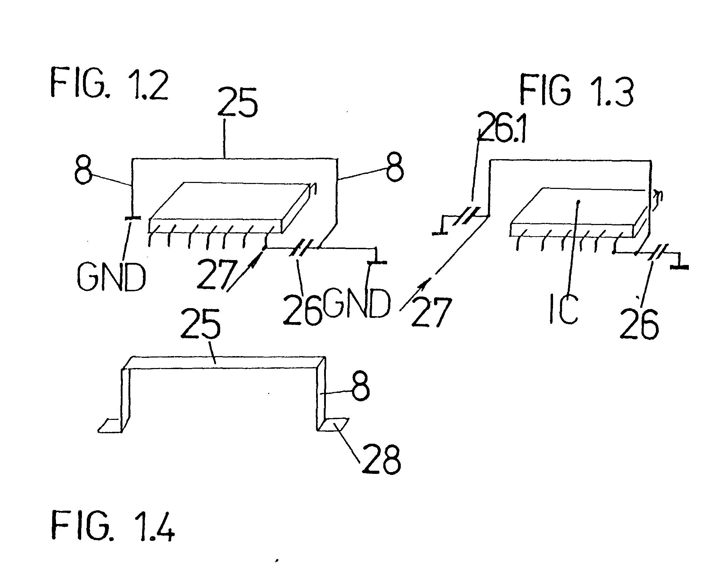

In Fig. 1 sind verschiedene Anordnungen von Kompensationselementen dargestellt, dabei in Fig. 1.1 Leiterkartenkompensationselemente und in Fig. 1.2 bis Fig. 1.4 IC-Kompensationselemente.

Die senkrechten Stege 8 in Fig. 1.1 können als Kontaktfedern ausgebildet sein, die mit GND der Leiterkarte 20 fest verbunden sind und mit ihren Kontaktflächen den Kompensationsleiter kontaktieren. Der Kompensationsleiter 25 ist als Blechstreifen (vgl. auch Fig. 1.4) im umgebenden Gehäuse in einem Abstand von ca. 2 cm parallel zur Leiterkarte angebracht. Die Verbindung der Kontaktfedern mit der Leiterkarte kann durch eine Löt-, Klebe- oder Steckverbindung erfolgen.

Bei den IC-Kompensationselementen nach Fig. 1.2 und 1.3 kann der gesamte Speisestrom des IC oder ein durch Stromteilung mit einem gegen GND führenden Leiterzug geteilten Strom genutzt werden. Dabei kann das Kompensationselement 8, 25 in den gegen GND führenden Ableitweg des IC-Blockkondensators 26 gegen GND geschaltet werden, so daß ein Teil des GND-seitige Blockkondensatorstrom über das Kompensationselement fließt (Fig. 1.2). Weiterhin kann das Kompensationselement als Hilfsenergiezuführung 27 in den zum IC-Anschluß und Blockkondensator 26 führenden Stromweg geschaltet werden (Fig. 1.3). Die dem Blockkondensator 26 abgewandte Seite erhält einen zusätzlichen Blockkondensator 26.1.

Die Stege 8 und der Kompensationsleiter 25 können aus einem gekanteten Blechteil bestehen, s. Fig. 1.4, welches an den unteren Enden der Stege 8 Lötanschlüsse 28 für SMD oder Durchsteckmontage besitzt. Der Rest der Schaltung befindet sich als Leiterzug oder GND-Fläche auf der Leiterkarte. Die Höhe des Bauteiles kann etwa 0,5 bis 2 cm betragen.

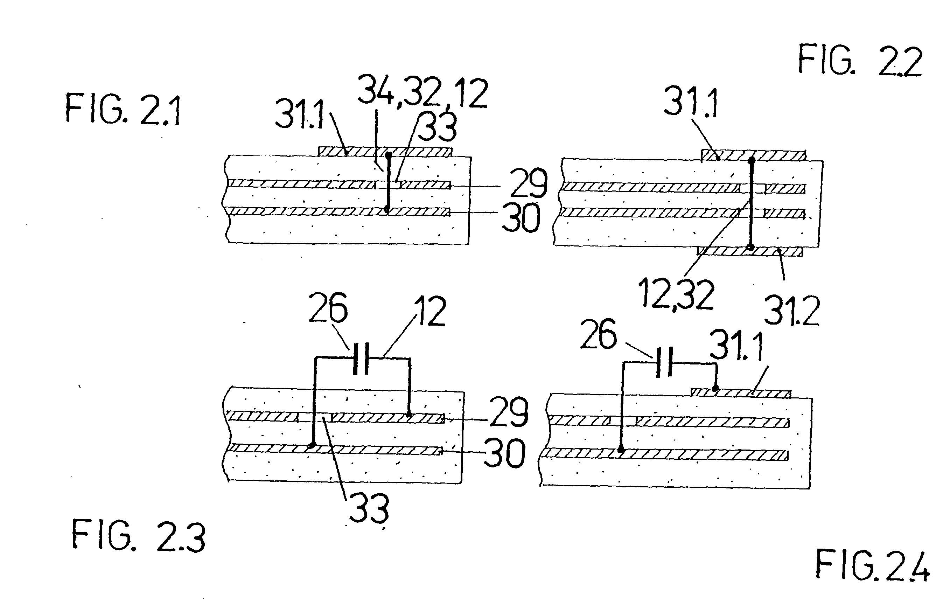

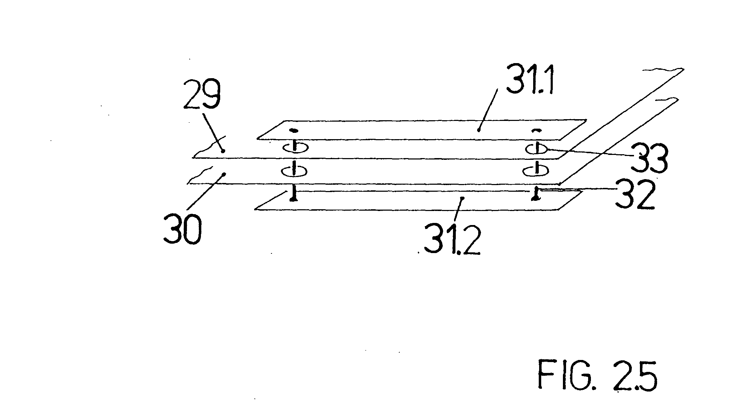

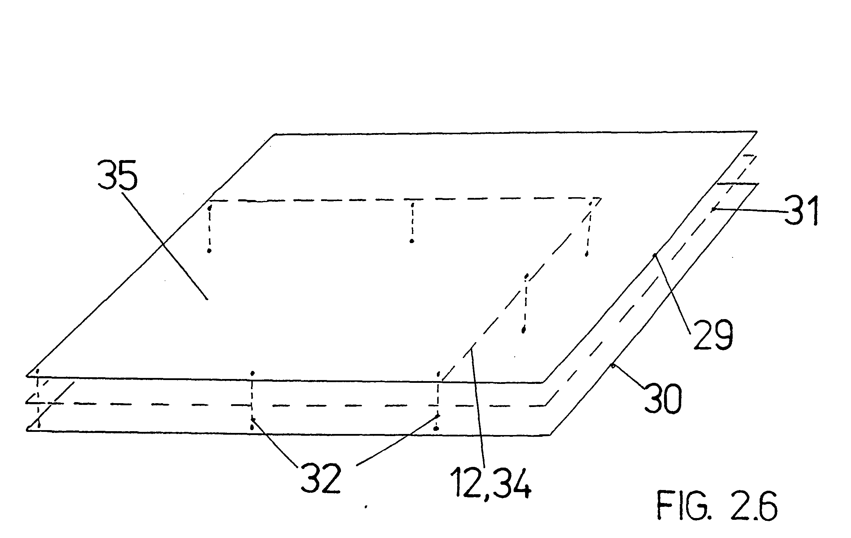

Fig. 2 zeigt verschiedene Ausführungen von Kurzschlußringstrukturen 12, 34 für aus GND-Plane A 29 und Vcc-Plane B 30 aufgebaute Multilayer.
Das aktive Gebiet wird in einer Lage der Multilayerkarte über und/oder unter der Fläche A 29 und B 30 geschlossen oder abschnittsweise mit einem Leiter C 31.1 und/oder D 31.2 umgeben. Der Leiter C 31.1 kann ca. 10 mm breit sein.

Die Kurzschlußringe 12 nach Fig. 2.1 entstehen von der Lage B 30 ausgehend über eine Durchkontaktierung 32, die über eine Bohrung 33 isoliert durch die Lage A 29 führt und mit dem Leiter C 31.1 verbunden ist. Der Leiter C 31.1 besitzt im Abstand von ca. 2 bis 10 cm eine weitere derartige Durchkontaktierung 32, so daß sich ein Kurzschlußring im Material der Leiterkarte in einer Kurzschlußringebene 34 senkrecht zur Leiterkartenebene bildet. Entscheidend dabei ist, daß der Kurzschlußring durch eine Bohrung 33 in der Lage A 29 geführt wird und damit die Lage A 29 die isolierte Durchkontaktierung 32 einschließt. Mehrere derartige Ringe können zusammenhängend oder mit Unterbrechungen das aktive Gebiet der Leiterkarte umgeben.

Von der Fläche A 29 und B 30 isolierte Kurzschlußringe, s. Fig. 2.2 und 2.5, ergeben sich, wenn ein ca. 1 cm breiter Leiter D 31.2 unterhalb vom Leiter C 31.1 unter der Fläche B 30 geführt wird und die Leiter C und D mit zwei im Abstand von 2 bis 5 cm befindliche Durchkontaktierungen 32 zu einem Kurzschlußring 12 zusammengefügt werden. Die Durchkontaktierungen werden isoliert über Bohrungen 33 durch die metallischen Lagen A und B geführt.

Ein Kurzschlußring 12 nach Fig. 2.3 ergibt sich, wenn die Lagen A 29 und B 30 mit zwei im Abstand von 2 bis 10 cm befindlichen Kondensatoren 26 verbunden werden.

Eine weitere Art von Kurzschlußring 12 gemäß Fig. 2.4 ergibt sich, wenn die Blockkondensatoren 26 an der Lage B 30 kontaktiert werden und isoliert durch die Lage A 29 geführt mit einem Leiter C verbunden werden. Der Leiter C und D kann ein Potentialausgleichsleiter oder Schirmleiter sein.

Fig. 2.6 beinhaltet die analog vertauschte Anordnung mit Metallflächen 29, 30 auf den Außenlagen und Leiterzügen 31 in den Innenlagen. Dabei ist mindestens das aktive Gebiet 35 mit Metallflächen 29, 30 überdeckt. Des weiteren ist das aktive Gebiet 35 durch die erfindungsgemäßen Kurzschlußringstrukturen 12, 34 in Form einer Kette von Kurzschlußringen 12 umgrenzt. Diese Kette entsteht, indem beide Metallflächen 29, 30 an den Rändern bzw. an der Umgrenzung des aktiven Gebietes 35 im Abstand von 2 bis 10 cm mittels Durchkontaktierungen 32 verbunden werden.

### Liste der Bezugszeichen

- 8 -: Stege

- 12 -: Kurzschlußring

- 20 -: Leiterkarte

- 25 -: Kompensationsleiter
- 26 -: Blockkondensator
- 26.1 -: zusätzlicher Blockkondensator
- 27 -: Hilfsenergieversorgung des IC
- 28 -: Lötanschluß des Kompensationselements
- 29 -: GND-Plane A
- 30 -: GND-Plane B
- 31 -: Leiter C, D
- 32 -: Durchkontaktierung
- 33 -: Bohrungen
- 34 -: Kurzschlußringebene
- 35 -: aktive Gebiete

## Patentansprüche

1. Anordnung zur Reduzierung der elektromagnetischen Abstrahlung bei Leiterkarten und IC,
**dadurch gekennzeichnet,** daß zur Herstellung eines Kurzschlußringes (12) mit einer Schleifenebene senkrecht zur Leiterkartenebene (L, B) Kompensationselemente, bestehend aus dem Kompensationsleiter (25) und mindestens zwei,
mit dem GND-System oder einem Leiterstreifen der Leiterkarte (20) verbundenen Stegen (8) vorhanden sind, wobei der gesamte Kompensationsleiter (25) oder nur ein Abschnitt als Teil des Kurzschlußringes (12) außerhalb der Leiterkarte (20) genutzt wird.

2. Anordnung nach Anspruch 1,
**dadurch gekennzeichnet,** daß der stab- oder flächenförmige Kompensationsleiter (25) in einem Abstand von etwa 1 bis 5 cm parallel zur Leiterkarte (20) geführt ist.

3. Anordnung nach Anspruch 1,
**dadurch gekennzeichnet**, daß die Kompensationselemente (25, 8) in einer kleineren Ausführung und in einem Abstandsbereich von 0,5 bis 2 cm für einzelne IC anwendbar sind, wobei passive IC-Kompensationselemente mit GND verbunden sind und aktive Kompensationselemente direkt oder über einen Stromteiler an die Hilfsenergieversorgung (27) des IC angeschlossen sind, und dabei das Kompensationselement in den gegen GND führenden Ableitweg des IC-Blockkondensators (26) gegen GND geschaltet ist oder das Kompensationselement als Hilfsenergiezuführung (27) in den zum IC-Anschluß mit Blockkondensator (bei Stromteilung) oder ohne Blockkondensator (26) führenden Stromweg geschaltet ist, wobei die dem IC-Anschluß abgewandte Seite mit einen zusätzlichen Blockkondensator (26.1) beschaltet ist.

4. Anordnung zur Reduzierung der elektromagnetischen Abstrahlung bei Leiterkarten und IC,
**dadurch gekennzeichnet**, daß zur Herstellung von Kurzschlußringstrukturen bei Multilayer-Leiterkarten eine Kurzschlußringebene (34) rechtwinklig zur Leiterkartenebene im Bereich einer GND-Plane A (29) und einer Vcc-Plane B (30) angeordnet ist, und dabei der Kurzschlußring (12) unter Nutzung eines Leiters C (31.1) etwa 2 bis 10 cm auf der Oberseite und/oder mittels eines Leiters D (31.2) auf der Unterseite des GND/Vcc-Plane-Systems geführt und mit Durchkontaktierungen (32) geschlossen ist, wobei der Kurzschlußring (31, 32) von GND und Vcc isoliert oder mit einem von beiden Potentialen (29, 30) verbunden ist, sowie die Durchkontaktierungen (32) über Bohrungen (33) erfolgen, die abhängig vom Aufbau der Kurzschlußringstruktur durch die metallischen Lagen A, B (29, 30) geführt sind.

5. Anordnung nach Anspruch 4,
**dadurch gekennzeichnet,** daß zur Führung der Kurzschlußringe über Flächen (29, 30) und Leitungen (31) unterschiedlicher Potentiale anstelle einfacher Durchkontaktierungen (32) Blockkondensatoren (26) vorgesehen sind.

6. Anordnung nach Anspruch 4 oder 5,
**dadurch gekennzeichnet,** daß aktive Gebiete (35) der GND/Vcc-Plane von einer Kette von Kurzschlußringen (12) umgeben sind.

## Claims

1. Arrangement for minimising the electromagnetic radiation in printed circuit boards and ICs
**characterized in that** for creating a short-circuiting ring (12) with a loop plane vertical to the printed circuit board plane (L, B), there are compensating elements consisting of the compensating conductor (25) and minimum two studs (8) connected to the GND-system or a conducting strip of the printed circuit board (20) with the entire compensating conductor (25) or only a section of it used as part of the short-circuiting ring (12) outside of the printed circuit board (20).

2. Arrangement to Claim 1
**characterized in that** the rod- or plane-shaped compensating conductor (25) is routed parallel with the printed circuit board (20) in a distance of approx. 1 to 5 cm.

3. Arrangement to Claim 1
**characterized in that** the compensating elements (25, 8) in a smaller version and in a range of distances of between 0.5 and 2 cm are usable for single ICs where passive compensating elements of the IC are connected to GND and active compensating elements are connected directly or over a current divider to the auxiliary power supply (27) of the IC, and the compensating element is connected to GND in the current leakage path to GND of the IC blocking capacitor or the compensating element as auxiliary power supply (27) is connected in the current path leading to the IC connection with blocking capacitor (with current division existing) or without blocking capacitor (26), with the side opposing the IC-connection equipped with an additional blocking capacitor (26.1).

4. Arrangement for minimising the electromagnetic radiation in printed circuit boards and ICs
**characterized in that** for creating short-circuiting ring structures in multilayer printed circuit boards a short-circuiting ring plane (34) is arranged vertical to the printed circuit board plane in the range of a GND-plane A (29) and a Vcc-plane B (30) and the short-circuiting ring (12) is routed using a conductor C (31.1) approx. 2 to 10 cm on the top side and/or by means of a conductor D (31.2) on the bottom side of the GND/Vcc-plane system and is closed by feed-throughs (32) where the short-circuiting ring (31, 32) is insulated from GND and Vcc, and where the feed-throughs (32) are made through holes (33) that lead through the metallic layers A, B (29, 30) depending on the design of the short-circuiting ring structure.

5. Arrangement to Claim 4
**characterized in that** for routing the short-circuiting rings over planes (29, 30) and lines (31) of different potentials blocking capacitors (26) are provided instead of simple feed-throughs (32).

6. Arrangement to Claim 4 or 5
**characterized in that** active areas (35) of the GND/Vcc planes are surrounded with a chain of short-circuiting rings (12).

## Revendications

1. Dispositif réduisant les radiations électromagnétiques dans les circuits imprimés et circuits intégrés (IC), caractérisé par le fait que la réalisation d'un anneau de court-circuit (12) dont le plan de rectification est situé à la verticale de la surface du circuit imprimé comprend un conducteur compensé (25) et au moins deux étançons (8) reliés au système GND ou à une lamelle conductrice du circuit imprimé (20), et où tout le conducteur de compensation (25) ou une seule section est utilisé comme partie de l'anneau court-circuit (12) à l'extérieur du circuit imprimé (20).

2. Dispositif en fonction de la spécification 1 caractérisé par le fait que le conducteur de compensation (25) de forme plate ou de barreau est introduit parallèlement à la carte conductrice (20) à un intervalle de 1 à 5 cm.

3. Dispositif en vertu de la spécification 1 caractérisé par le fait que les élements de compensation (25, 8) sont applicables pour des circuits imprimés individuels par une petite application et un écartement de 0,5 à 2 cm, où des élements de compensation de circuit intégré (IC) passifs sont reliés avec un GND et les éléments de compensation actifs reliés à l'alimentation en énergie auxiliaire (27) du circuit intégré (IC) directement ou au moyen d'un conducteur de courant. A cet effet l'élement de compensation est branché dans la conduite de dérivation du condensateur de blocage du circuit intégré (IC) (26) conduisant contre le GND ou l'élément de compensation est branché en tant qu'aducteur d'énergie auxiliaire (27) dans le circuit électrique conduisant à la connexion du circuit intégré (IC) avec le condensateur de blocage (en cas de partage du courant) ou sans condensateur de blocage (26), et qu'à cet effet le côté inverse de la connexion du circuit intégré est branché à un condensateur de blocage supplémentaire (26.1).

4. Dispositif réduisant les radiations électromagnétiques dans les circuits imprimés et circuits intégrés (IC) caractérisé par le fait que pour la fabrication de structures de court-circuit circulaire en cas de circuits imprimés Multilayer une surface de court-circuit circulaire (34) est apposée d'équerre à la surface du circuit imprimé dans la zone d'une plaque A GND (29) et une plaque Vcc B (30). Dans ce cas, lors de l'utilisation d'un conducteur C (31.1) l'anneau de court-circuit (12) est placé à environ 2 à 10 cm sur la face supérieure et/ou au moyen d'un conducteur D (31.2) sur le face inférieure du système de plaques GND/Gcc et maintenu fermé au moyens de lamelles de contact (32) et à cet effet l'anneau de court-circuit (31, 32) est isolé du GND et du Vcc ou relié à l'un des deux potentiels (29, 30) de même que les contacts (32) sont mis en place grâce à des trous (33) réalisés en relation avec la construction de la structure circulaire de court-circuit à travers les couches métaliques A, B (29,39).

5. Dispositif en fonction de la spécification 4 caractérisé par le fait que des condensateurs de blocage (26) sont prévus à la place de simples lamelles de contact afin d'assurer la conduite des anneaux de court-circuit sur les surfaces (29, 30) et conduites de différents potentiels.

6. Dispositif en fonction des spécifications 4 ou 5 caractérisée par le fait que les régions actives (35) de la plaque GND/Vcc sont entourée d'une chaîne d'anneaux de court-circuit (12).
